# EUROPÄISCHE PATENTSCHRIFT

(11) **EP 3 630 484 B1**
(45) Veröffentlichungstag und Bekanntmachung des Hinweises auf die Patenterteilung: **09.08.2023**
(21) Anmeldenummer: 18723000.8
(22) Anmeldetag: 08.05.2018
(51) Int. Cl.: B32B 17/10, B32B 1/00, H10K 59/00, H10K 77/10

(54) **GEBOGENE VERBUNDGLASSCHEIBE MIT EINEM EINGELASSENEN GEBOGENEN ZUSAMMENHÄNGENDEN DISPLAY UND VERFAHREN ZUR HERSTELLUNG DERSELBEN**
CURVED LAMINATE SHEET GLASS HAVING INCORPORATED DISPLAY AND A METHOD FOR MANUFACTURING THE SAME
VITRAGE COMPOSITE CINTRÉ COMPRENANT UN ÉCRAN ENCASTRÉ ET SON PROCÉDÉ DE FABRICATION

(30) Priorität: 24.05.2017 EP 17172782
(43) Veröffentlichungstag der Anmeldung: 08.04.2020
(73) Patentinhaber: SAINT-GOBAIN GLASS FRANCE, 92400 Courbevoie (FR)
(72) Erfinder: WEBER, Patrick, 52477 Alsdorf (DE); KIZMAZ, Ali-Osman, 52146 Würselen (DE); BORHANI HAGHIGHI, Sara, 52070 Aachen (DE)
(74) Vertreter: Gebauer, Dieter Edmund
(86) Internationale Anmeldenummer: PCT/EP2018/061837
(87) Internationale Veröffentlichungsnummer: WO 2018/215199

(56) Entgegenhaltungen:
- US-A1- 2011 025 584

## Beschreibung

Die Erfindung betrifft eine gebogene Verbundglasscheibe mit einem eingelassenen gebogenen zusammenhängenden Display und Verfahren zur Herstellung derselben.

In vielen Bereichen besteht der Wunsch Displays in Glasscheiben zu integrieren.

Beispielsweise ist aus dem US Patent 7,892,616 B2 ein Verfahren bekannt, bei dem mit Hilfe von Adaptern ein starres Element mit einem Glaselement verbunden werden kann.

Weiterhin ist beispielsweise aus der US Patentanmeldung 2011 / 0 169 705 A1 bekannt, eine Vielzahl von starren Elemente in einer Glas-Scheibe verbunden mittels flexibler Kabel anzuordnen.

Aus dem US Patent 5,208,080 ist ein Verfahren zum Laminieren von halb-starrem Material zwischen Glas bekannt.

Weiterhin zeigt die Europäischen Patentanmeldung EP 2 926 388 A1 das Laminieren eines elektronischen bzw. opto-elektronischen Gerätes.

Allerdings besteht in zunehmendem Maße auch eine Nachfrage nach komplexeren Glasflächen, in denen ein Display eingelassen ist.

Mit den bisherigen Verfahren sind jedoch zum Beispiel gebogene Glasflächen mit innenliegenden Displays nur äußerst schwer herzustellen, indem Abstandhalter mit komplexen Profilen eingebracht werden, die ein Einlegen eines starren Displays in eine gebogene Verbundglasscheibe im Profil ausgleichen.

Aus der US 2015 / 0 303 404 A1 ist es bekannt ein starres OLED Display in eine Verbundglasscheibe einzufügen.

Aus der CN 2052503691 U ist eine gerade Glasscheibe mit einer OLED bekannt.

Aus der US 2011 / 0 025 574 A1 ist ein Head-Up Display bekannt, das auf die Innenseite einer fertigen Windschutzscheibe aufgebracht wird.

Aus der DE 10 2007 012 571 A1 ist eine Frontscheibe mit einem starren OLED-Display bekannt, wobei die entstehenden Hohlräume durch Glyzerin aufgefüllt werden. Ist das OLED-Display groß, so sieht die Schrift vor, die Scheiben entsprechend anzuschleifen. Damit ist aber die Größe eines Displays abhängig von der Krümmung und der Dicke der Scheiben. Neben einer aufwändigen Herstellung ist zudem die Langzeitstabilität der so hergestellten Scheibe insbesondere auch in Bezug auf das zu verwendende Füllmaterial problematisch.

Dies führt dazu, dass z.B. bei Verbundglas-Scheiben mit einem komplexeren Profil bestimmte Bereiche nicht oder nur für sehr kleine Displays verwendbar sind. D.h. Displays können nicht frei platziert werden.

Zudem ist festzustellen, dass bei Displays die Elektronik im Vergleich zur Displayfläche einen nur geringen Teil einnimmt. Daher ergibt sich neben der Notwendigkeit der Anpassung der Profile an die Biegung zudem eine Notwendigkeit der Anpassung an unterschiedliche Dicken.

Insbesondere bei großen Displays und/oder bei starken Biegungen führt dies dazu, dass es entweder zu Spannungen an den Rändern der Displays und damit zu einer Beschädigung der Displays am Rande kommt oder aber, dass die Dicke einer Verbundglas-Scheibe erheblich zunimmt.

Ebenso ergibt sich ein Problem in Bezug auf die Elektronikschicht. Wird das Anpassungsprofil nicht ausreichend dimensioniert, so treten Spannungen an der Elektronik auf, die diese beschädigen können. Dies ist insbesondere dann zu verzeichnen, wenn die Elektronik in engem Kontakt zu einer Glas-Schicht ist, insbesondere, wenn die Elektronik unmittelbar auf der Glas-Schicht aufliegt.

Vor diesem Hintergrund stellt sich die Aufgabe der Bereitstellung einer gebogenen Verbundglasscheibe mit einem eingelassenen Display.

Die Aufgabe wird gelöst durch ein Verfahren zur Herstellung einer gebogenen Verbundglasscheibe mit einem eingelassenen gebogenen zusammenhängenden Display. Dabei weist die Verbundglasscheibe eine erste gebogenen Glas-Schicht und ein zweite gebogene Glas-Schicht auf, wobei das Display eine Displayschicht und eine Elektronikschicht aufweist. Die Displayschicht und die Elektronikschicht sind unterschiedlich ausgeformt, wobei die Displayschicht eine erste Schichtdicke und die Elektronikschicht eine zweite Schichtdicke ausweist. Zwischen der Elektronikschicht und der zweiten Glas-Schicht ist eine erste Zwischenfolie angeordnet, die die gleiche Fläche aufweist, wie die Elektronikschicht. Die erste Zwischenfolie weist eine dritte Schichtdicke auf. Benachbart zur Elektronikschicht und der ersten Zwischenfolie ist eine zweite Zwischenfolie angeordnet, die eine Schichtdicke der Summe der zweiten Schichtdicke und der dritten Schichtdicke aufweist. Benachbart zur Displayschicht ist eine dritte Zwischenfolie angeordnet, die in etwa eine Schichtdicke entsprechend der ersten Schichtdicke aufweist. Die Verbundglasscheibe weist weiterhin eine erste Verbindungsschicht zwischen der ersten Glas-Schicht und der dritten Zwischenfolie und zwischen der ersten Glas-Schicht und der Displayschicht auf. Die Verbundglasscheibe weist weiterhin eine zweite Verbindungsschicht zwischen der zweiten Glas-Schicht und der ersten Zwischenfolie und zwischen der zweiten Glas-Schicht und der zweiten Zwischenfolie auf. Das Verfahren weist einen Schritt des Erhaltens der ersten gebogenen Glas-Schicht und der zweiten gebogenen Glas-Schicht, den Schritt des Erhaltens eines ungebogenen zusammenhängenden Displays auf. Weiterhin weist das Verfahren den Schritt des Anordnens des erhaltenen Displays zwischen den gebogenen Glas-Schichten auf, sodass benachbart zur Displayschicht die dritte Zwischenfolie angeordnet ist, und sodass benachbart zur Elektronikschicht und der ersten Zwischenfolie die zweite Zwischenfolie angeordnet ist, wobei oberhalb der Display-Schicht die erste Verbindungsschicht angeordnet ist, und wobei unterhalb der ersten Zwischenfolie die zweite Verbindungsschicht angeordnet ist. Die Anordnung wird in einem weiteren Schritt zumindest im Bereich des Displays bei einer Temperatur von 50°C - 100°C erwärmt, sodass unter Einfluss der Erwärmung die Displayschicht als auch die Elektronikschicht sich verbiegen und sich an die Biegung der ersten Glas-Schicht bzw. zweiten Glas-Schicht angleichen. Anschließend werden die so vorverarbeiten gebogenen Schichten mittels eines Autoklaven verbunden.

D.h., mittels der Erfindung wird es ermöglicht auch großformatige (zuvor ungebogene) zusammenhängende Displays in gebogenen Scheiben einzubringen, ohne dass die Scheibendicke negativ beeinträchtigt wird bzw. ohne Gefahr zu laufen, dass entweder die Displayschicht oder die Elektronikschicht gefährdet sind.

In einer Ausgestaltung der Erfindung beinhaltet der Schritt des Erwärmens einen Temperaturanstieg in einem Zeitraum von mehr als 30 Minuten.

Durch den verhältnismäßig langen Temperaturanstieg wird die Displayschicht als auch die Elektronikschicht so langsam erwärmt, dass die Elektronikschicht als auch die Displayschicht, die aus unterschiedlichen Materialien aufgebaut sind, sich gleichmäßig erwärmen, sodass keine großen Temperaturgradienten entstehen, die zu Rissen in der Elektronik bzw. der Verbindung der Elektronikschicht zur Displayschicht führen könnten.

Die Aufgabe wird auch gelöst durch eine Verbundglasscheibe, die nach einem der erfindungsgemäßen Verfahren hergestellt ist.

In einer Ausführungsform der Erfindung enthalten die Zwischenschichten zumindest einen Stoff ausgewählt aus der Gruppe aufweisend Polybutylenterephthalat (PBT), Polycarbonat (PC), Polyethylenterephthalat (PET) und Polyethylennaphthalat (PEN), Polyvinylchlorid (PVC), Polyvinylfluoride (PVF), Polyvinylbutyral (PVB), Ethylenvinylacetat (EVA), Polyacrylat (PA), Polymethylmethacrylat (PMMA), Polyurethan (PUR), und/oder Gemische und Copolymere davon.

In einer Ausführungsform der Erfindung enthalten die Verbindungsschichten zumindest einen Stoff ausgewählt aus der Gruppe aufweisend Polybutylenterephthalat (PBT), Polycarbonat (PC), Polyethylenterephthalat (PET) und Polyethylennaphthalat (PEN), Polyvinylchlorid (PVC), Polyvinylfluoride (PVF), Polyvinylbutyral (PVB), Ethylenvinylacetat (EVA), Polyacrylat (PA), Polymethylmethacrylat (PMMA), Polyurethan (PUR), und/oder Gemische und Copolymere davon.

Mit dem vorgestellten Verfahren kann somit mit einer Vielzahl von Materialien gearbeitet werden.

In einer Ausführungsform der Erfindung kann das Display in Bezug auf die erste Glas-Schicht außerhalb der Mitte angeordnet sein. D.h., die Erfindung erlaubt eine freie Anordnung eines Displays.

In einer weiteren Ausführungsform der Erfindung ist das Display ein OLED-Display.

Somit können auch kostengünstige Displays verarbeitet werden.

In noch einer weiteren Ausführungsform der Erfindung nimmt das Display eine Fläche von weniger als 20 % der ersten Glas-Schicht ein.

D.h. es können auch große Displays verbaut werden.

Gemäß einer weiteren Ausführungsform der Erfindung weist das Display eine Displaydiagonale von mindestens 12cm auf.

Hiermit können Displays für unterschiedliche Zwecke zur Verfügung gestellt werden.

Die so hergestellten Verbundglasscheiben können z.B. in Fahrzeugen oder Gebäuden oder als Informationsdisplay verwendet werden.

Ausführungsformen der vorliegenden Erfindung werden in exemplarischer Weise mit Bezug auf die angehängten Zeichnungen beschrieben, in denen zeigt:
- Fig. 1: eine schematische Schnitt-Darstellung von Verbundglasscheibe während der Herstellung gemäß erfindungsgemäßer Verfahren,
- Fig. 2: eine schematische Schnitt-Darstellung eines Details der Erfindung,
- Fig. 3: eine schematische Schnitt-Darstellung eines weiteren Details der Erfindung,
- Fig. 4: eine schematische Schnitt-Darstellung von Verbundglasscheibe nach der Herstellung gemäß erfindungsgemäßer Verfahren,
- Fig. 5: ein Flussdiagramm mit Schritten gemäß erfindungsgemäßer Verfahren, und
- Fig. 6: eine Anordnung eines Displays in einer erfindungsgemäßen Verbundglasscheibe.

### Ausführliche Darstellung der Erfindung in Bezug auf die Zeichnungen

Nachfolgend wird die Erfindung eingehender unter Bezugnahme auf die Figur dargestellt werden. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden soweit nicht explizit als reine Alternative dargestellt.

Weiterhin wird nachfolgend der Einfachheit halber in aller Regel immer nur auf eine Entität Bezug genommen werden. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

In den nachfolgend beschriebenen Verfahren können einzelne Schritte in einem einzigen Schritt verkörpert sein und z.B. parallel zueinander ausgeführt werden. Zudem kann die Reihenfolge von Verfahrensschritten variieren, sodass die vorgestellte Reihenfolge der Verfahrensschritte nicht als zwingend anzusehen ist, es sei denn es wird eine bestimmte Reihenfolge als explizit notwendig beschrieben.

Nachfolgend wird Bezug auf ein Display genommen. Ein Display weist eine Vielzahl von einzeln ansteuerbaren elektrischen Elementen auf, die entweder aktiv leuchten oder durch Steuerung die Reflektivität oder Transmission ändern, sodass Licht einer anderen Quelle gesteuert werden kann.

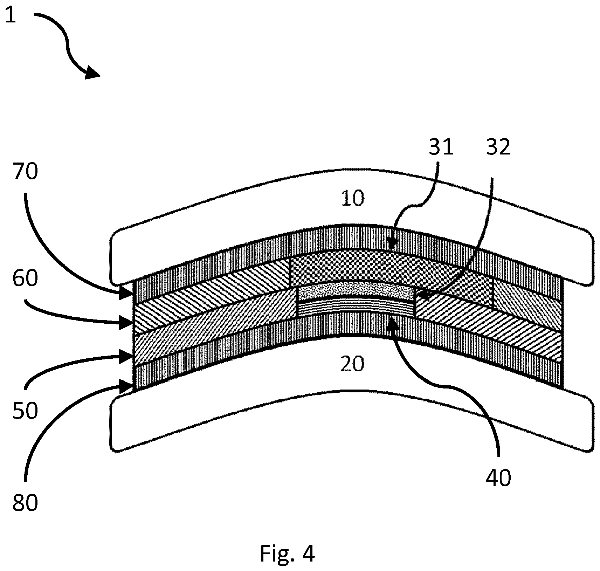

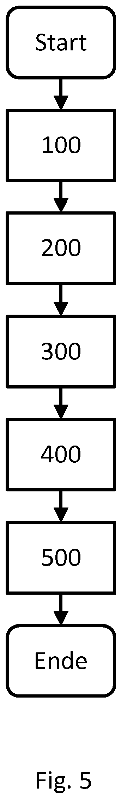

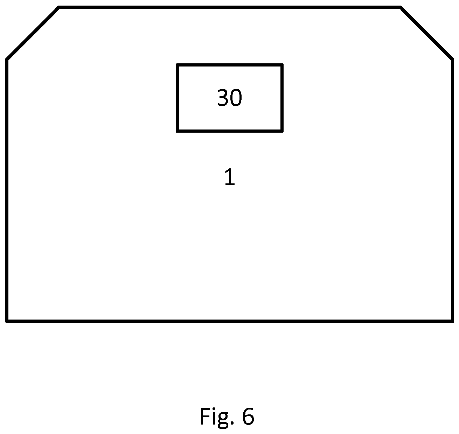

Das erfindungsgemäße Verfahren zur Herstellung einer gebogenen Verbundglasscheibe 1 mit einem eingelassenen zusammenhängenden Display 30 ist in Figur 5 dargestellt. Mit dem erfindungsgemäßen Verfahren wird eine Verbundglasscheibe 1 hergestellt, welche in einem Schnitt als Endprodukt in Figur 4 dargestellt ist, und welche in Figur 6 schematisch als eine Aufsicht in Bezug auf das zusammenhängenden Display 30 gezeigt ist.

Die Verbundglasscheibe 1 weist eine erste gebogenen Glas-Schicht 10 und ein zweite gebogene Glas-Schicht 20 auf.

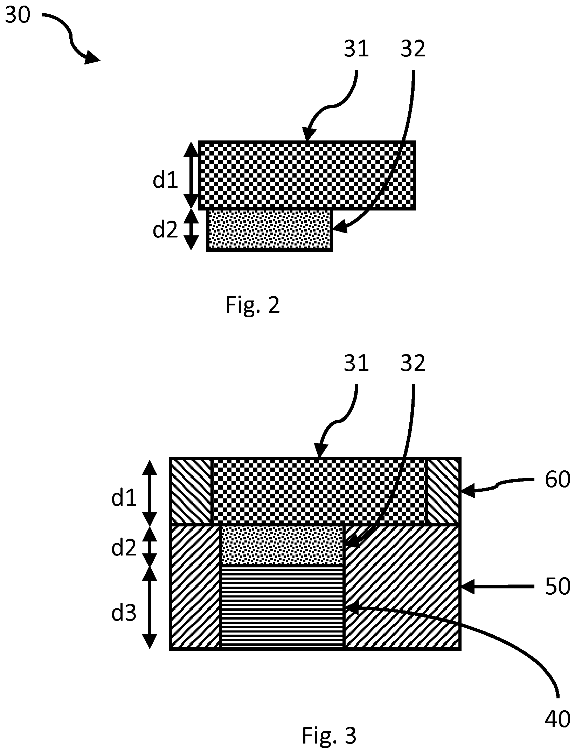

Das zusammenhängende Display 30, welches als Schnitt in Figur 2 gezeigt ist, weist eine Displayschicht und eine Elektronikschicht auf, wobei die Displayschicht 31 und die Elektronikschicht 32 unterschiedlich ausgeformt sind. In Figur 3 ist beispielsweise dargestellt, dass die Displayschicht 31 eine andere horizontale Erstreckung als die Elektronikschicht 32 aufweist. Alternativ oder zusätzlich kann zudem die Dicke (vertikale Erstreckung) der Displayschicht 31 eine andere sein als die Dicke (vertikale Erstreckung) der Elektronikschicht 32.

Die Displayschicht 31 weist, wie in Figur 2 und 3 gezeigt, eine erste Schichtdicke d1 und die Elektronikschicht 32 eine zweite Schichtdicke d2 auf.

Zwischen der Elektronikschicht und der zweiten Glas-Schicht ist eine erste Zwischenfolie 40 angeordnet, die in etwa die gleiche Fläche aufweist, wie die Elektronikschicht 32. Es sei dabei angemerkt, dass der Begriff "gleich" als auch der Begriff "in etwa" toleranzbehaftet ist, sodass Abweichungen von bis zu 10 % als im Wesentlichen gleich angesehen werden.

Die erste Zwischenfolie 40 weist eine dritte Schichtdicke d3 auf.

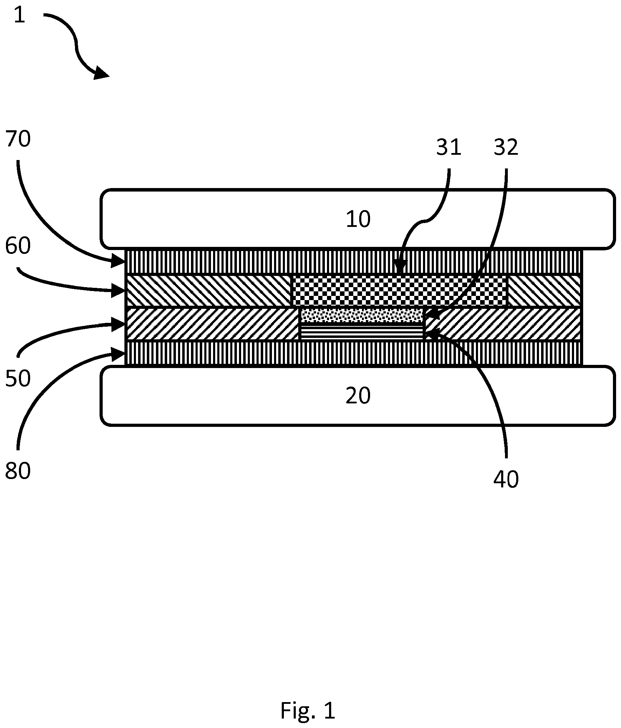

Benachbart zur Elektronikschicht 32 und der ersten Zwischenfolie 40 ist - wie in Figur 1 und 3 ersichtlich - eine zweite Zwischenfolie 50 angeordnet, die in etwa eine Schichtdicke der Summe der zweiten Schichtdicke d2 und der dritten Schichtdicke d3 aufweist.

Benachbart zur Displayschicht 31 ist eine dritte Zwischenfolie 60 angeordnet, die in etwa eine Schichtdicke entsprechend der ersten Schichtdicke d1 aufweist.

D.h. mittels der unterschiedlichen Schichtdicken können unterschiedliche Höhenprofile der Elektronikschicht 32 als auch der Displayschicht 12 ausgeglichen werden, sodass sich in einem Zwischenschritt im Wesentlichen eine Anordnung gemäß Figur 1 ergibt, bei der die unterschiedlichen Höhen durch unterschiedlich dicke Zwischenfolien ausgeglichen werden. Zudem stellt die Zwischenfolie 40 auf der Elektronikschicht 32 einen Wärmepuffer dar, sodass der Temperaturanstieg gleichmäßiger verteilt werden kann und die Bildung einer Wärmebrücke zur Glas-Schicht 20 vermieden wird.

Die Materialien der einzelnen Zwischenfolien können unterschiedlich gewählt sein, sodass sich z.B. unterschiedliche Temperaturleiteigenschaften für die Verarbeitung der Verbundglasscheibe 1 als auch im Betrieb des Displays 30 ergeben. Beispielsweise kann durch die Zwischenfolie 40 eine verbesserte Wärmeverteilung zur Verfügung gestellt werden, sodass zum einen bei der Herstellung es nicht zu thermischen Hotspots und damit unterschiedlichem optischen Verhalten kommt, zum anderen im Betrieb des Displays 30 Wärme gleichmäßiger abgeleitet werden kann, wodurch die Haltbarkeit des Displays 30 verbessert wird. Zudem können mit den unterschiedlichen Zwischenfolien auch andere Funktionen, wie z.B. eine Antireflexbeschichtung, Wärmeleitung, etc. bereitgestellt werden.

Die Verbundglasscheibe weist weiterhin eine erste Verbindungsschicht 70 zwischen der ersten Glas-Schicht 10 und der dritten Zwischenfolie 60 und zwischen der ersten Glas-Schicht 10 und der Displayschicht 31 auf.

Die Verbundglasscheibe weist weiterhin eine zweite Verbindungsschicht 80 zwischen der zweiten Glas-Schicht 20 und der ersten Zwischenfolie 40 und zwischen der zweiten Glas-Schicht 20 und der zweiten Zwischenfolie 50 auf.

Das erfindungsgemäße Verfahren zur Herstellung weist nunmehr zunächst den Schritt 100 des Erhaltens der ersten gebogenen Glas-Schicht 10 und der zweiten gebogenen Glas-Schicht 20 und den Schritt 200 des Erhaltens eines ungebogenen Displays 30 auf.

Das erhaltene ungebogene zusammenhängende Display 30 wird in Schritt 300 zwischen der ersten gebogenen Glas-Schicht 10 und der zweiten gebogenen Glas-Schicht 20 angeordnet, sodass benachbart zur Displayschicht 31 die dritte Zwischenfolie 60 angeordnet ist, und sodass benachbart zur Elektronikschicht 32 und der ersten Zwischenfolie 40 die zweite Zwischenfolie 50 angeordnet ist, wobei oberhalb der Display-Schicht 31 die erste Verbindungsschicht 70 angeordnet ist, und wobei unterhalb der ersten Zwischenfolie 40 die zweite Verbindungsschicht 80 angeordnet ist.

Beispielsweise kann zunächst auf die erste Glas-Schicht 10 die erste Verbindungsschicht 70 aufgelegt werden. Anschließend wird auf die erste Verbindungsschicht 70 das zusammenhängende Display 30 gelegt, wobei die Display-Schicht 31 in Kontakt mit der ersten Verbindungsschicht 70 ist. Anschließend wird die dritte Zwischenfolie 60 als (Vielzahl von) Streifen oder Pass-partout um die Display-Schicht 31 herum gelegt. Hierauf kann sodann die zweite Zwischenfolie 50 um die Elektronikschicht 32 herum als (Vielzahl von) Streifen oder Pass-partout gelegt. In die dabei entstehende Vertiefung über der Elektronikschicht 32 wird nunmehr eine Fläche der ersten Zwischenfolie 40 aufgelegt. Anschließend wird eine erste Verbindungsschicht 80 aufgelegt. Hierauf wird sodann die zweite Glas-Schicht 20 aufgelegt. Dabei entsteht eine nahezu flache Anordnung mit nahezu gleichmäßigem Höhenprofil.

Die Anordnung wird sodann in einem Schritt 400 zumindest im Bereich des Displays 30 bei einer Temperatur von 50°C - 100°C erwärmt, sodass unter Einfluss der Erwärmung die Displayschicht 31 als auch die Elektronikschicht 32 sich verbiegen und sich an die Biegung der ersten Glas-Schicht 10 bzw. zweiten Glas-Schicht 20 angleichen. Angleichen ist dabei ebenso ein toleranzbehafteter Begriff. D.h. die Display-Schicht als auch die Elektronikschicht verbiegen sich, wobei die Biegeradien bis an den Biegeradius der Glas-Schichten 10 bzw. 20 heranreichen. D.h. der Schritt des Erwärmens entspannt das Material der Displayschicht 31 als auch der Elektronikschicht 32 und führt zumindest teilweise dies in den Bereich des Phasenübergangs.

Anschließend wird das so gebogene zusammenhängende Display 30 mit den anderen Schichten mittels eines Autoklaven in einem Schritt 500 verbunden.

D.h., mittels der Erfindung wird es ermöglicht auch großformatige (zuvor ungebogene) Displays in gebogenen Scheiben einzubringen, ohne dass die Scheibendicke negativ beeinträchtigt wird bzw. ohne Gefahr zu laufen, dass entweder die Displayschicht oder die Elektronikschicht gefährdet sind.

Zudem ist festzustellen, dass die als Ergebnis erhaltene Verbundglasscheibe 1 bessere Transparenzeigenschaften aufweist. Insbesondere zeigt sich, dass es zu weniger optischen Störungen auf Grund des gleichmäßigen Erwärmens kommt. Ist die Erwärmung ungleichmäßig, so kann dies zu ungleichmäßigem Schmelzen und damit zu optischen Störungen führen.

In einer Ausführungsform der Erfindung beinhaltet der Schritt des Erwärmens 400 einen Temperaturanstieg in einem Zeitraum von mehr als 30 Minuten.

Durch den verhältnismäßig langen Temperaturanstieg wird die Displayschicht 31 als auch die Elektronikschicht 32 so langsam erwärmt, dass die Elektronikschicht 32 als auch die Displayschicht 31, die je aus unterschiedlichen Materialien aufgebaut sind, sich gleichmäßig erwärmen, sodass keine großen Temperaturgradienten entstehen, die zu Rissen in der Elektronik bzw. der Verbindung der Elektronikschicht zur Displayschicht führen könnten.

Beispielsweise kann dieser Schritt des Erwärmens eine Erwärmung auf 90° C und Halten der Temperatur über einen Zeitraum von mehreren Stunden, z.B. 18 h, beinhalten.

Dabei können sich die Zeiten und Temperaturen für unterschiedlich große als auch unterschiedliche stark zu biegenden Displays 30 unterscheiden. Ohne Weiteres ist es dabei möglich auch nur den Bereich des Displays und der nahen Umgebung zu erwärmen, da im Wesentlichen nur das Display 30 unter Einfluss der Wärme und der einwirkenden Gewichtskräfte (langsam) gebogen werden muss.

Die Aufgabe wird auch gelöst durch eine Verbundglasscheibe 1, die nach einem der erfindungsgemäßen Verfahren hergestellt ist.

In einer Ausführungsform der Erfindung enthält die erste Zwischenfolie 40 und /oder die zweite Zwischenfolie 50 und/oder dritte Zwischenfolie 60 zumindest einen Stoff ausgewählt aus der Gruppe aufweisend Polybutylenterephthalat (PBT), Polycarbonat (PC), Polyethylenterephthalat (PET) und Polyethylennaphthalat (PEN), Polyvinylchlorid (PVC), Polyvinylfluoride (PVF), Polyvinylbutyral (PVB), Ethylenvinylacetat (EVA), Polyacrylat (PA), Polymethylmethacrylat (PMMA), Polyurethan (PUR), und/oder Gemische und Copolymere davon.

In einer Ausführungsform der Erfindung enthält die erste Verbindungsschicht 70 und / oder die zweite Verbindungsschicht 80 zumindest einen Stoff ausgewählt aus der Gruppe aufweisend Polybutylenterephthalat (PBT), Polycarbonat (PC), Polyethylenterephthalat (PET) und Polyethylennaphthalat (PEN), Polyvinylchlorid (PVC), Polyvinylfluoride (PVF), Polyvinylbutyral (PVB), Ethylenvinylacetat (EVA), Polyacrylat (PA), Polymethylmethacrylat (PMMA), Polyurethan (PUR), und/oder Gemische und Copolymere davon.

Mit dem vorgestellten Verfahren kann somit mit einer Vielzahl von Materialien gearbeitet werden. Insbesondere kann auch mit herkömmlichen Materialsystemen gearbeitet werden.

In einer Ausführungsform der Erfindung kann das Display 30 in Bezug auf die erste Glas-Schicht 10 der Verbundglasscheibe 1 außerhalb der Mitte angeordnet sein. Eine solche Anordnung ist in Figur 6 gezeigt. D.h., die Erfindung erlaubt eine freie Anordnung eines Displays.

In einer weiteren Ausführungsform der Erfindung ist das Display 30 ein OLED-Display. Somit können auch kostengünstige Displays verarbeitet werden. Andere Displays 30, insbesondere solche mit einer dünnen Glas-Schicht oder anderen Darstellungsverfahren wie z.B. e-Paper, sind von dem erfindungsgemäßen Verfahren nicht ausgeschlossen.

In noch einer weiteren Ausführungsform der Erfindung nimmt das Display 30 eine Fläche von weniger als 20 % der ersten Glas-Schicht 10 ein. D.h. es können auch große Displays verbaut werden.

Gemäß einer weiteren Ausführungsform der Erfindung weist das Display 30 eine Displaydiagonale von mindestens 12 cm auf. Beispielsweise können mit Displays von 12 cm Diagonale oder mehr als Rückspiegel (in Zusammenarbeit mit einer Rücksicht-/Rückfahrkamera) in Fahrzeugen verwendet werden. Andere Größen, z.B. 17 cm - 33 cm und mehr, erlauben eine Verwendung als Informationsdisplay, als Navigationssystem, Telefon, Multimediawiedergabegerät, Man-Machine-Interface, etc.

Andere Größen und andere Verwendungszwecke, z.B. als Hinweisgeber / Statusanzeigen etc. in kleinen Displays sind natürlich ebenso realisierbar. Ohne Weiteres ist es natürlich auch möglich die gesamte Größe der Verbundglas-Scheibe 1 als Display zu verwenden.

Wird eine große Fläche der Verbundglasscheibe 1 durch das Display 30 eingenommen kann dies abhängig von der Transparenz des Displays 30 die Verwendung für bestimmte Zwecke, z.B. als Informationsdisplay / steuerbare gebogene Trennwandscheibe erlauben.

Ohne Beschränkung der Allgemeinheit kann an den Verbundglasscheiben natürlich auch ein Anschlusselement auf einer der Glas-Schichten und/oder am Rand der Verbundglasscheibe 1 vorgesehen sein, die einen Anschluss an die Elektronikschicht 32 zur Verfügung stellt.

Die so hergestellten Verbundglasscheiben können z.B. in Fahrzeugen, z.B. als Front-, Heck- oder Seitenscheibe, oder in Gebäuden oder als Informationsdisplay verwendet werden.

Das erfindungsgemäße Verfahren erlaubt eine kostengünstige Herstellung auf Basis (deutlich günstigerer) ungebogener zusammenhängenden Displays 30.

### Bezugszeichenliste

- 1: Verbundglasscheibe
- 10: erste gebogene Glas-Schicht
- 20: zweite gebogene Glas-Schicht
- 30: zusammenhängendes Display
- 10: erste gebogene Glas-Schicht
- 20: zweite gebogene Glas-Schicht
- 31: Displayschicht
- 32: Elektronikschicht
- 40: erste Zwischenfolie
- 50: zweite Zwischenfolie
- 60: dritte Zwischenfolie
- 70: erste Verbindungsschicht
- 80: zweite Verbindungsschicht
- d1: erste Schichtdicke
- d2: zweite Schichtdicke
- d3: dritte Schichtdicke

### Verfahrensschritte

- 100: Erhalten der ersten gebogenen Glas-Schicht und der zweiten gebogenen Glas-Schicht
- 200: Erhalten eines im Wesentlichen ungebogenen Displays
- 300: Anordnen des erhaltenen Displays
- 400: Erwärmen der Anordnung
- 500: Verbinden der angeordneten gebogenen Schichten mittels eines Autoklaven

## Patentansprüche

1. Verfahren zur Herstellung einer gebogene Verbundglasscheibe (1) mit einem eingelassenen gebogenen zusammenhängendem Display (30), die Verbundglasscheibe (1) aufweisend eine erste gebogene Glas-Schicht (10) und ein zweite gebogene Glas-Schicht (20), wobei das Display (30) eine Displayschicht (31) und eine Elektronikschicht (32) aufweist, wobei die Displayschicht (31) und die Elektronikschicht (32) unterschiedlich ausgeformt sind, wobei die Displayschicht (31) eine erste Schichtdicke (d1) und die Elektronikschicht (32) eine zweite Schichtdicke (d2) aufweisen, wobei zwischen der Elektronikschicht (32) und der zweiten Glas-Schicht (20) eine erste Zwischenfolie (40) angeordnet ist, die die gleiche Fläche aufweist, wie die Elektronikschicht (32) und eine dritte Schichtdicke (d3) aufweist, und wobei benachbart zur Elektronikschicht (32) und der ersten Zwischenfolie (40) eine zweite Zwischenfolie (50) angeordnet ist, die eine Schichtdicke der Summe der zweiten Schichtdicke (d2) und der dritten Schichtdicke (d3) aufweist, und wobei benachbart zur Displayschicht (31) eine dritte Zwischenfolie (60) angeordnet ist, die in etwa eine Schichtdicke entsprechend der ersten Schichtdicke (d1) aufweist, wobei die Verbundglasscheibe (1) weiterhin eine erste Verbindungsschicht (70) zwischen der ersten Glas-Schicht (10) und der dritten Zwischenfolie (60) und zwischen der ersten Glas-Schicht (10) und der Displayschicht (31) aufweist, und eine zweite Verbindungsschicht (80) zwischen der zweiten Glas-Schicht (20) und der ersten Zwischenfolie (40) und zwischen der zweiten Glas-Schicht (20) und der zweiten Zwischenfolie (50) aufweist, aufweisend die Schritte
- Erhalten (100) der ersten gebogenen Glas-Schicht (10) und der zweiten gebogenen Glas-Schicht (20),
- Erhalten (200) eines ungebogenen zusammenhängenden Displays (30),
- Anordnen (300) des erhaltenen Displays (30) zwischen den gebogenen Glas-Schichten (10, 20), sodass benachbart zur Displayschicht (31) die dritte Zwischenfolie (60) angeordnet ist, und sodass benachbart zur Elektronikschicht (32) und der ersten Zwischenfolie (40) die zweite Zwischenfolie (50) angeordnet ist, wobei oberhalb der Display-Schicht (31) die erste Verbindungsschicht (70) angeordnet ist, und wobei unterhalb der ersten Zwischenfolie (40) die zweite Verbindungsschicht (80) angeordnet ist,
- Erwärmen der Anordnung (400) zumindest im Bereich des Displays (30) bei einer Temperatur von 50°C - 100°C, sodass unter Einfluss der Erwärmung die Displayschicht (31) als auch die Elektronikschicht (32) sich verbiegen und sich an die Biegung der ersten Glas-Schicht bzw. zweiten Glas-Schicht angleichen,
- Verbinden (500) der angeordneten gebogenen Schichten mittels eines Autoklaven.

2. Verfahren nach Anspruch 1, wobei der Schritt des Erwärmens (400) einen Temperaturanstieg in einem Zeitraum von mehr als 30 Minuten beinhaltet.

3. Gebogene Verbundglasscheibe (1) mit einem eingelassenen gebogenen zusammenhängendem Display (30), erhalten nach dem Verfahren gemäß Anspruch 1 und 2, aufweisend eine erste gebogene Glas-Schicht (10) und ein zweite gebogene Glas-Schicht (20), wobei das Display (30) eine Displayschicht (31) und eine Elektronikschicht (32) aufweist, wobei die Displayschicht (31) und die Elektronikschicht (32) unterschiedlich ausgeformt sind, wobei die Displayschicht (31) eine erste Schichtdicke (d1) und die Elektronikschicht (32) eine zweite Schichtdicke (d2) aufweisen, wobei zwischen der Elektronikschicht (32) und der zweiten Glas-Schicht (20) eine erste Zwischenfolie (40) angeordnet ist, die die gleiche Fläche aufweist, wie die Elektronikschicht (32) und eine dritte Schichtdicke (d3) aufweist, und wobei benachbart zur Elektronikschicht (32) und der ersten Zwischenfolie (40) eine zweite Zwischenfolie (50) angeordnet ist, die eine Schichtdicke der Summe der zweiten Schichtdicke (d2) und der dritten Schichtdicke (d3) aufweist, und wobei benachbart zur Displayschicht (31) eine dritte Zwischenfolie (60) angeordnet ist, die in etwa eine Schichtdicke entsprechend der ersten Schichtdicke (d1) aufweist, wobei die Verbundglasscheibe (1) weiterhin eine erste Verbindungsschicht (70) zwischen der ersten Glas-Schicht (10) und der dritten Zwischenfolie (60) und zwischen der ersten Glas-Schicht (10) und der Displayschicht (31) aufweist, und eine zweite Verbindungsschicht (80) zwischen der zweiten Glas-Schicht (20) und der ersten Zwischenfolie (40) und zwischen der zweiten Glas-Schicht (20) und der zweiten Zwischenfolie (50) aufweist.

4. Verbundglasscheibe (1) nach Anspruch 3, wobei die Zwischenschichten (40, 50, 60) zumindest einen Stoff ausgewählt aus der Gruppe aufweisend Polybutylenterephthalat (PBT), Polycarbonat (PC), Polyethylenterephthalat (PET) und Polyethylennaphthalat (PEN), Polyvinylchlorid (PVC), Polyvinylfluoride (PVF), Polyvinylbutyral (PVB), Ethylenvinylacetat (EVA), Polyacrylat (PA), Polymethylmethacrylat (PMMA), Polyurethan (PUR), und/oder Gemische und Copolymere davon enthält.

5. Verbundglasscheibe (1) nach Anspruch 3 oder 4, wobei die Verbindungsschichten (70, 80) zumindest einen Stoff ausgewählt aus der Gruppe aufweisend Polybutylenterephthalat (PBT), Polycarbonat (PC), Polyethylenterephthalat (PET) und Polyethylennaphthalat (PEN), Polyvinylchlorid (PVC), Polyvinylfluoride (PVF), Polyvinylbutyral (PVB), Ethylenvinylacetat (EVA), Polyacrylat (PA), Polymethylmethacrylat (PMMA), Polyurethan (PUR), und/oder Gemische und Copolymere davon enthält.

6. Verbundglasscheibe (1) nach einem der Ansprüche 3 bis 5, wobei das Display (30) in Bezug auf die erste Glas-Schicht außerhalb der Mitte angeordnet ist.

7. Verbundglasscheibe (1) nach einem der Ansprüche 3 bis 6, wobei das Display (30) ein OLED-Display ist.

8. Verbundglasscheibe (1) nach einem der Ansprüche 3 bis 7, wobei das Display (30) eine Fläche von weniger als 20 % der ersten Glas-Schicht einnimmt.

9. Verbundglasscheibe (1) nach einem der Ansprüche 3 bis 8, wobei das Display (30) eine Displaydiagonale von mindestens 12cm aufweist.

10. Verwendung einer Verbundglasscheibe (1) nach einem der Ansprüche 3 bis 8 in Fahrzeugen oder Gebäuden oder als Informationsdisplay.

## Claims

1. Method for producing a curved composite glass panel (1) with an embedded curved coherent display (30), the composite glass panel (1) having a first curved glass layer (10) and a second curved glass layer (20), wherein the display (30) has a display layer (31) and an electronics layer (32), wherein the display layer (31) and the electronics layer (32) are shaped differently, wherein the display layer (31) has a first layer thickness (d1) and the electronics layer (32) has a second layer thickness (d2), wherein a first intermediate film (40) is arranged between the electronics layer (32) and the second glass layer (20), which first intermediate film has the same area as the electronics layer (32) and has a third layer thickness (d3), and wherein a second intermediate film (50) is arranged adjacent the electronics layer (32) and the first intermediate film (40), which second intermediate film has a layer thickness equal to the sum of the second layer thickness (d2) and the third layer thickness (d3), and wherein a third intermediate film (60) is arranged adjacent the display layer (31), which third intermediate film has a layer thickness roughly corresponding to the first layer thickness (d1), wherein the composite glass panel (1) further has a first bonding layer (70) between the first glass layer (10) and the third intermediate film (60) and between the first glass layer (10) and the display layer (31), and has a second bonding layer (80) between the second glass layer (20) and the first intermediate film (40) and between the second glass layer (20) and the second intermediate film (50), having the steps
- Obtaining (100) the first curved glass layer (10) and the second curved glass layer (20),
- Obtaining (200) a non-curved coherent display (30),
- Arranging (300) the display (30) obtained between the curved glass layers (10, 20) such that the third intermediate film (60) is arranged adjacent the display layer (31), and such that the second intermediate film (50) is arranged adjacent the electronics layer (32) and the first intermediate film (40), wherein the first bonding layer (70) is arranged above the display layer (31), and wherein the second bonding layer (80) is arranged below the first intermediate film (40),
- Warming the assembly (400) at least in the region of the display (30) at a temperature of 50 °C - 100 °C such that, under the influence of the warming, the display layer (31) and the electronics layer (32) bend and adapt to the curve of the first glass layer or second glass layer,
- Bonding (500) the arranged curved layers by means of an autoclave.

2. Method according to claim 1, wherein the step of warming (400) includes a temperature rise in a period of more than 30 minutes.

3. Curved composite glass panel (1) with an embedded curved coherent display (30), obtained by the method according to claim 1 and 2,
having a first curved glass layer (10) and a second curved glass layer (20), wherein the display (30) has a display layer (31) and an electronics layer (32), wherein the display layer (31) and the electronics layer (32) are shaped differently, wherein the display layer (31) has a first layer thickness (d1) and the electronics layer (32) has a second layer thickness (d2), wherein a first intermediate film (40) is arranged between the electronics layer (32) and the second glass layer (20), which first intermediate film has the same area as the electronics layer (32) and has a third layer thickness (d3), and wherein a second intermediate film (50) is arranged adjacent the electronics layer (32) and the first intermediate film (40), which second intermediate film has a layer thickness equal to the sum of the second layer thickness (d2) and the third layer thickness (d3), and wherein a third intermediate film (60) is arranged adjacent the display layer (31), which third intermediate film has a layer thickness roughly corresponding to the first layer thickness (d1), wherein the composite glass panel (1) further has a first bonding layer (70) between the first glass layer (10) and the third intermediate film (60) and between the first glass layer (10) and the display layer (31), and has a second bonding layer (80) between the second glass layer (20) and the first intermediate film (40) and between the second glass layer (20) and the second intermediate film (50).

4. Composite glass panel (1) according to claim 3, wherein the intermediate layers (40, 50, 60) contain at least one material selected from the group comprising polybutylene terephthalate (PBT), polycarbonate (PC), polyethylene terephthalate (PET) and polyethylene naphthalate (PEN), polyvinyl chloride (PVC), polyvinyl fluorides (PVF), polyvinyl butyral (PVB), ethylene vinyl acetate (EVA), polyacrylate (PA), polymethyl methacrylate (PMMA), polyurethane (PUR), and/or mixtures and copolymers thereof.

5. Composite glass panel (1) according to claim 3 or 4, wherein the bonding layers (70, 80) contain at least one material selected from the group comprising polybutylene terephthalate (PBT), polycarbonate (PC), polyethylene terephthalate (PET) and polyethylene naphthalate (PEN), polyvinyl chloride (PVC), polyvinyl fluorides (PVF), polyvinyl butyral (PVB), ethylene vinyl acetate (EVA), polyacrylate (PA), polymethyl methacrylate (PMMA), polyurethane (PUR), and/or mixtures and copolymers thereof.

6. Composite glass panel (1) according to one of claims 3 through 5, wherein the display (30) is arranged outside the center relative to the first glass layer.

7. Composite glass panel (1) according to one of claims 3 through 6, wherein the display (30) is an OLED display.

8. Composite glass panel (1) according to one of claims 3 through 7, wherein the display (30) occupies an area of less than 20% of the first glass layer.

9. Composite glass panel (1) according to one of claims 3 through 8, wherein the display (30) has a display diagonal of at least 12 cm.

10. Use of composite glass panel (1) according to one of claims 3 through 8 in vehicles or buildings or as an information display.

## Revendications

1. Procédé de fabrication d'un panneau de verre composite bombé (1) avec un écran cohérent bombé intégré (30), le panneau de verre composite (1) ayant une première couche de verre bombé (10) et une seconde couche de verre bombé (20), l'écran (30) ayant une couche d'affichage (31) et une couche électronique (32), la couche d'affichage (31) et la couche électronique (32) ayant des formes différentes, dans lequel la couche d'affichage (31) a une première épaisseur de couche (d1) et la couche électronique (32) a une deuxième épaisseur de couche (d2), dans lequel un premier film intermédiaire (40) est placé entre la couche électronique (32) et la deuxième couche de verre (20), lequel premier film intermédiaire a la même surface que la couche électronique (32) et a une troisième épaisseur de couche (d3), et dans lequel un deuxième film intermédiaire (50) est placé à côté de la couche électronique (32) et du premier film intermédiaire (40), dans lequel un deuxième film intermédiaire (50) est placé à côté de la couche électronique (32) et du premier film intermédiaire (40), ce deuxième film intermédiaire ayant une épaisseur égale à la somme de l'épaisseur de la deuxième couche (d2) et de l'épaisseur de la troisième couche (d3), et dans lequel un troisième film intermédiaire (60) est placé à côté de la couche d'affichage (31), ce troisième film intermédiaire ayant une épaisseur correspondant à peu près à l'épaisseur de la première couche (d1), dans lequel le panneau de verre composite (1) comporte en outre une première couche de liaison (70) entre la première couche de verre (10) et le troisième film intermédiaire (60) et entre la première couche de verre (10) et la couche d'affichage (31), et comporte une deuxième couche de liaison (80) entre la deuxième couche de verre (20) et le premier film intermédiaire (40) et entre la deuxième couche de verre (20) et le deuxième film intermédiaire (50), en procédant aux étapes suivantes
- Obtention (100) de la première couche de verre bombé (10) et de la seconde couche de verre bombé (20),
- Obtention (200) d'un écran cohérent non bombé (30),
- Disposer (300) l'écran (30) obtenu entre les couches de verre incurvées (10, 20) de telle sorte que le troisième film intermédiaire (60) soit adjacent à la couche d'affichage (31) et que le deuxième film intermédiaire (50) soit adjacent à la couche électronique (32) et au premier film intermédiaire (40), la première couche de liaison (70) étant disposée au-dessus de la couche d'affichage (31) et la deuxième couche de liaison (80) étant disposée au-dessous du premier film intermédiaire (40),
- Chauffer l'assemblage (400) au moins dans la zone de l'écran (30) à une température de 50 °C - 100 °C de sorte que, sous l'influence du réchauffement, la couche d'affichage (31) et la couche électronique (32) se courbent et s'adaptent à la courbe de la première couche de verre ou de la deuxième couche de verre,
- Coller (500) les couches courbes disposées au moyen d'un autoclave.

2. Procédé selon la revendication 1, dans lequel l'étape de réchauffement (400) comprend une augmentation de la température pendant une période de plus de 30 minutes.

3. Panneau composite en verre bombé (1) avec un écran cohérent bombé intégré (30), obtenu par la méthode selon les revendications 1 et 2,
comportant une première couche de verre bombé (10) et une seconde couche de verre bombé (20), dans lequel l'écran (30) comporte une couche d'affichage (31) et une couche électronique (32), dans lequel la couche d'affichage (31) et la couche électronique (32) ont des formes différentes, dans lequel la couche d'affichage (31) a une première épaisseur de couche (d1) et la couche électronique (32) a une seconde épaisseur de couche (d2), dans lequel un premier film intermédiaire (40) est placé entre la couche électronique (32) et la deuxième couche de verre (20), ce premier film intermédiaire ayant la même surface que la couche électronique (32) et une troisième épaisseur de couche (d3), et dans lequel un deuxième film intermédiaire (50) est placé à côté de la couche électronique (32) et du premier film intermédiaire (40), dans lequel un deuxième film intermédiaire (50) est placé à côté de la couche électronique (32) et du premier film intermédiaire (40), ce deuxième film intermédiaire ayant une épaisseur égale à la somme de l'épaisseur de la deuxième couche (d2) et de l'épaisseur de la troisième couche (d3), et dans lequel un troisième film intermédiaire (60) est placé à côté de la couche d'affichage (31), ce troisième film intermédiaire ayant une épaisseur correspondant à peu près à l'épaisseur de la première couche (d1), dans lequel le panneau de verre composite (1) comporte en outre une première couche de liaison (70) entre la première couche de verre (10) et le troisième film intermédiaire (60) et entre la première couche de verre (10) et la couche d'affichage (31), et comporte une deuxième couche de liaison (80) entre la deuxième couche de verre (20) et le premier film intermédiaire (40) et entre la deuxième couche de verre (20) et le deuxième film intermédiaire (50).

4. Panneau composite en verre (1) selon la revendication 3, dans lequel les couches intermédiaires (40, 50, 60) contiennent au moins un matériau choisi dans le groupe comprenant le polybutylène téréphtalate (PBT), le polycarbonate (PC), le polyéthylène téréphtalate (PET) et le polyéthylène naphtalate (PEN), le chlorure de polyvinyle (PVC), les fluorures de polyvinyle (PVF), le butyral de polyvinyle (PVB), l'éthylène-acétate de vinyle (EVA), le polyacrylate (PA), le polyméthacrylate de méthyle (PMMA), le polyuréthane (PUR), et/ou leurs mélanges et copolymères.

5. Panneau composite en verre (1) selon la revendication 3 ou 4, dans lequel les couches de liaison (70, 80) contiennent au moins un matériau choisi dans le groupe comprenant le polybutylène téréphtalate (PBT), le polycarbonate (PC), le polyéthylène téréphtalate (PET) et le polyéthylène naphtalate (PEN), le chlorure de polyvinyle (PVC), les fluorures de polyvinyle (PVF), le butyral de polyvinyle (PVB), l'éthylène-acétate de vinyle (EVA), le polyacrylate (PA), le polyméthacrylate de méthyle (PMMA), le polyuréthane (PUR), et/ou leurs mélanges et copolymères.

6. Panneau composite en verre (1) selon l'une des revendications 3 à 5, dans lequel l'écran (30) est disposé à l'extérieur du centre par rapport à la première couche de verre.

7. Panneau de verre composite (1) selon l'une des revendications 3 à 6, dans lequel l'écran (30) est un écran OLED.

8. Panneau de verre composite (1) selon l'une des revendications 3 à 7, dans lequel l'écran (30) occupe une surface inférieure à 20 % de la première couche de verre.

9. Panneau de verre composite (1) selon l'une des revendications 3 à 8, dans lequel l'écran (30) a une diagonale d'affichage d'au moins 12 cm.

10. Utilisation du panneau de verre composite (1) selon l'une des revendications 3 à 8 dans des véhicules ou des bâtiments ou comme écran d'information.
